# EUROPEAN PATENT SPECIFICATION

(11) **EP 2 272 165 B1**
(45) Date of publication and mention of the grant of the patent: **26.03.2014**
(21) Application number: 09741952.7
(22) Date of filing: 02.04.2009
(51) Int. Cl.: H03K 17/00

(54) **BISTABLE HALL-EFFECT MAGNETIC PROXIMITY SENSOR**
BISTABILER MAGNETISCHER NÄHERUNGSSENSOR MIT HALLEFFEKT
CAPTEUR DE PROXIMITÉ MAGNÉTIQUE À EFFET HALL BISTABLE

(30) Priority: 06.05.2008 IT PN20080035
(43) Date of publication of application: 12.01.2011
(73) Proprietor: Stem S.r.l., 27010 Cura Carpignano (Pavia) (IT)
(72) Inventor: MORO, Simone, 27100 Pavia (IT)
(74) Representative: Giugni, Valter
(86) International application number: PCT/EP2009/053944
(87) International publication number: WO 2009/135734

(56) References cited:
- EP-A- 1 452 475
- WO-A-2007/129504
- DE-C1- 4 221 625
- FR-A- 2 587 106
- US-B1- 6 867 680

## Description

The present invention refers to a bistable Hall-effect magnetic proximity sensor, which is particularly suitable for integration in systems provided to control the movement of a moving platform in general.

As is largely known in the art, e.g. US-6867680B1, WO-2007/129504A, a magnetic proximity sensor may be of either a monostable kind or a bistable kind. A sensor belonging to either one of these typologies may be used in connection with a wide variety of applications in different fields of industrial automation; anyway, it is certainly - and above all - largely used in connection with equipment and apparatus falling within the general domain of moving platforms, wherein these moving platforms may be understood as including all kinds of lifting equipment, such as for instance elevators, gods lifts, hoists, chair lifts, escalators, stair lifts and elevators, aerial or overhead platforms, and the like, but also crane jibs and booms, moving staircases, passenger conveyors, and the like.

As far as the operation of these sensors, i.e. the way in which they work is concerned, the above-cited two kinds of magnetic proximity sensors, i.e. the monostable and the bistable ones, differ from each other owing substantially to the stable state that the sensor is able to assume and maintain. Specifically, a monostable magnetic proximity sensor may be in an energization or activation state when affected by, i.e. exposed to the effects of a magnetic field, whereas it may be in a de-energization or de-activation state when it is no longer exposed to such effects. A bistable magnetic proximity sensor may on the contrary be able to maintain either one of said two stable activation and de-activation states, respectively, as long as an opposite magnetic pole is not applied.

By way of example, and to illustrative purposes, reference will be made hereinafter to an elevator apparatus in which a bistable magnetic proximity sensor is used to indicate an end-of-travel condition of an elevator car, or lift cage, moving inside a lift shaft, i.e. when the lift cage reaches either one of an uppermost and a lowermost floor.

As attached to the lift cage, the bistable magnetic proximity sensor keeps in an activation state when the cage is travelling along the lift shaft, whereas it keeps in a de-activation state when the cage is at an end-of-travel level. The state of the sensor changes when the sensor moves in proximity of an outer magnetic body provided in the lift shaft just slightly in advance of the uppermost floor or just slightly in advance of the lowermost floor. The sensor may be arranged to deliver an indication of the state condition thereof to a control unit, such as for instance a microcontroller, a DSP, a computer, a PLC, or the like, via a respective output signal.

In an end-of-travel condition, the de-activation state signal delivered by the sensor to the control unit will indicate that there are no further floors beyond the one being reached, and that a subsequent operation of the lift cage can only occur in a reverse travelling direction as opposed to the one being completed.

As a final safety provision, there are provided further end-of-travel devices of a mechanical type, i.e. the so-called extra-run end-of-travel devices, to stop the cage in case that it keeps travelling for an additional running length beyond the limits.

Among all magnetic proximity sensors known in the art, those based on the Hall effect have the advantage of ensuring proven reliability records, since the operation thereof of fully and solely of an electronic nature, i.e. a fact that makes these sensors far more resistant to mechanical shocks, actually. In addition, a Hall-effect magnetic proximity sensor is particularly adapted to be interconnected with a control unit thanks to the speed of response and the degree of accuracy it is able to ensure.

The operation of a Hall-effect magnetic proximity sensor is based on the physical phenomenon carrying the same name, according to which a magnetic field being applied orthogonally to a direction of a current density relating to charge carriers that move longitudinally in a conductive, i.e. current-carrying material, generates a force that urges the charge carriers transversally relative to the direction of the current density so as to gather them up along a border of the conductive material. Such charge build-up along the border of the conductive material gives practically rise to a difference in potential between two mutually opposite sides of the same conductive materials, i.e. the so-called Hall voltage.

In a throughout general manner, it can be stated that a basic circuit diagram of a Hall-effect chip may include a current stabilizer and regulator circuit for a current used to supply and energize the various stages that make up the same chip. These stages substantially comprise a Hall generator stage generating the Hall voltage; this stage is then followed by an amplifier stage that acts directly on such Hall voltage to amplify it. The output signal issuing from this amplifier stage may in this way be ready for appropriate processing in an either analogue or logic circuit, or there may be provided a further stage, such as a so-called Schmitt trigger. The latter may in turn be followed by a connection with a final transistor in a given configuration thereof, in view of delivering an output signal that is suitable to appropriately drive a digital circuit.

The Hall-effect chip is included in a printed-circuit board that is provided with soldering lands, or contact pads, for connection with lead wires. The printed-circuit board itself is housed inside a casing that forms the actual housing of the Hall-effect magnetic proximity sensor as a whole.

Hall-effect magnetic proximity sensors may differentiate from each others so as to be either of the monostable kind or the bistable kind when they are provided to include a different Hall-effect chip that is either monostable or bistable, respectively.

With reference to the sole Hall-effect magnetic proximity sensors of the bistable kind, it is generally known that such sensors are not able to keep or retain its activation or de-activation state under each and every operating condition. In the case of a temporary power-supply failure, in fact, a bistable Hall-effect magnetic proximity sensor gives off, i.e. loses the state it had in a moment preceding the power-supply failure and, when the power supply is then restored, i.e. it is switched on again, it always and in all cases re-initializes in the activation state thereof.

Such kind of shortcoming gives rise to a number of unwelcome drawbacks, actually. So, for instance, if the power-supply failure is interrupted and then immediately restored while the elevator cage is in an extra-run condition, the bistable Hall-effect magnetic proximity sensor might re-initialize by assuming the activation state, instead of the de-activation one, to thereby deliver the enable signal to the control unit that would allow the elevator cage to resume extra-run travelling, i.e. a condition that had on the contrary be prevented from occurring.

In an attempt to solve these problems and do away therewith, some solutions have in fact been proposed. An example of such solutions is disclosed in the European patent application no. 1 452 475 filed by this same Applicant, in which there is described an electrically powered control arrangement for people and freight elevators and lifts.

Such electrically powered control arrangement comprises at least a bistable Hall-effect magnetic proximity sensor adapted to identify an end-of-travel condition of a car, i.e. cage at the extreme top and bottom floors. The control arrangement also comprises a memory carrier to continuously record the state of the bistable Hall-effect magnetic proximity sensor and to keep the last recorded state in store even in the case of a power failure. As a result, in the case that the power supply fails and is then restored, it is possible for the bistable Hall-effect magnetic proximity sensor to be re-initialized with the same state as the one it was assuming in a moment immediately preceding the power-supply failure.

A drawback that is likely to be encountered with a solution of the above-cited kind, however, tends to occur when the bistable Hall-effect magnetic proximity sensor moves in front of and passes by an external magnetic body placed in a travelling shaft of the elevator cage just slightly in advance of the uppermost or top floor or just slightly in advance of the lowermost or bottom floor under a power-supply failure condition. In this case, in fact, the sensor is not able to switch over to its de-activation state, due to its being turned off, actually, and the memory carrier fails therefore to be duly updated with such state parameter. When the power supply is then restored, the thus non-updated activation state being stored in the memory carrier is read out and applied to the sensor and, in this way, the protection ensured by the respective end-of-travel arrangement is practically bypassed.

It therefore is a purpose of the present invention to do away with the drawbacks encountered in the prior art by providing an improved kind of bistable Hall-effect magnetic proximity sensor which is able to keep the stable state thereof under any and all operating conditions whatsoever, regardless of the sensor being energized or not, i.e. of the power-supply state of the sensor.

Another, equally important purpose of the present invention is to provide a bistable Hall-effect magnetic proximity sensor which is capable of being produced with production means and methods as they are readily available and largely used in the art.

According to the present invention, these aims, advantages and features thereof, along with further ones that shall become apparent from the following description, are reached in a bistable Hall-effect magnetic proximity sensor embodying the characteristics as recited and defined in the appended independent claims and sub-claims.

Anyway, features and advantages of the present invention will be more readily understood from the description of an exemplary embodiment that is given below by way of non-limiting example with reference to the accompanying drawings, in which:
- Figure 1 is a schematical, perspective view of the interior of a bistable Hall-effect magnetic proximity sensor according to an embodiment of the present invention;
- Figure 2 is a schematical, perspective exploded view of a rotating magnetic element of the sensor illustrated in Figure 1;
- Figures 3A, 3B and 3C are views of a first basic circuit diagram of the sensor illustrated in Figure 1, with a transistor-based output and a related printed-circuit board; and
- Figures 4A, 4B and 4C are views of a second basic circuit diagram of the sensor illustrated in Figure 1, with a relay-based output and a related printed-circuit board, according to a modified embodiment of the present invention.

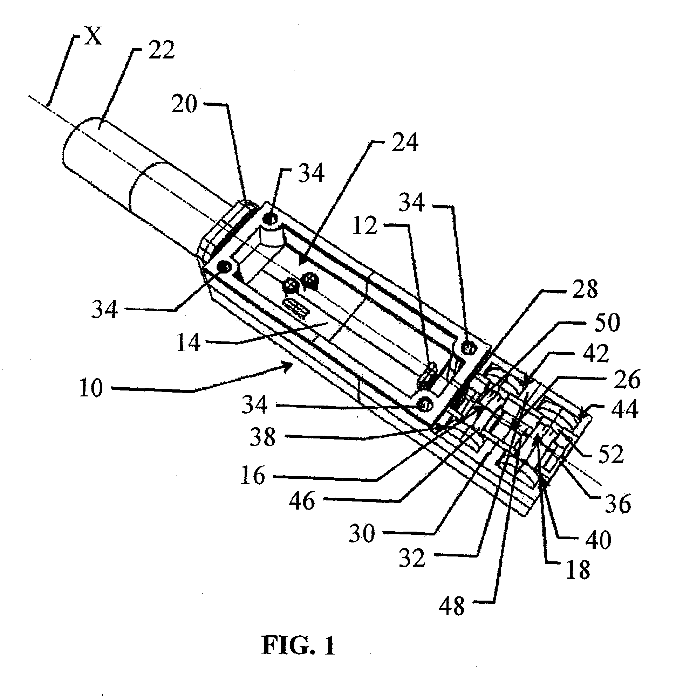

With reference to Figure 1, a bistable Hall-effect magnetic proximity sensor covered by the present invention comprises a casing 10 formed of a part in the shape of a parallelepiped and a threaded terminal part in the shape of a cylinder 22, which are joined to each other by means of a collar in the shape of a nut 20; it further includes a cover (not shown), a printed-circuit board 14, a monostable Hall-effect chip 12, and at least a first magnetic rotating element 16 and a second magnetic rotating element 18.

The casing 10 has a structure that develops, i.e. extends substantially longitudinally, i.e. in a lengthwise direction along an axis X, and is open on one side thereof that can be closed by joining a cover thereupon, in an inherently known manner. To such purpose, in the casing 10 there are provided a plurality of coupling means 34 that are adapted to couple with a corresponding plurality of complementary coupling means provided in the cover, in a manner that is largely known as such in the art. The parallelepiped-shaped part of the casing 10 is subdivided internally into a first section 24 and a second section 26 that are oriented longitudinally and separated from each other by a demarcation surface 28. This demarcation wall shall however not be necessarily provided; in alternative embodiments, it may in fact be omitted and a sealing gasket may be extended to also include the section 26.

The first section 24 is shaped internally so as to be adapted to accommodate the printed-circuit board 14 along with all its components mounted thereon. Coupling means of a kind as largely known as such in the art enable the printed-circuit board 14 to be secured to the first section 24.

A suitable socket connector for plugging in the pins of the monostable Hall-effect chip 12 is provided at an end portion of the printed-circuit board 14 close to the demarcation surface 28. The monostable Hall-effect chip 12 can therefore be mounted onto such socket so as to stand facing the demarcation surface 28. In addition, the printed-circuit board 14 is provided with soldering lands for lead wires issuing from the final threaded cylindrical part 22 to be connected thereto.

The above-mentioned final threaded cylindrically-shaped part 22 of the casing 10 is provided to enable the sensor to be mounted and secured either via a support that has already been patented by this same Applicant, or by means of a nut and locknut in any support whatsoever provided with a through-bore.

The second section 26 is, for example, in the shape of substantially a parallelepiped and has a first side wall 30 and a second side wall 32 lying opposite to the first one, both said side walls being provided to extend longitudinally. The first side wall 30 is made to a given cross-sectional thickness so that a first and a second pocket-like accommodating recesses 38, 40 can be provided in a longitudinal arrangement. Similarly, the second side wall 32 is made to a given cross-sectional thickness so that a third and a fourth pocket-like accommodating recesses 42, 44 can be provided in a longitudinal arrangement.

The pocket-like recess 38 is substantially symmetrical to the pocket-like recess 42 relative to the axis X. Similarly, the pocket-like recess 40 is substantially symmetrical to the pocket-like recess 44 relative to the axis X. These pocket-like recesses 38, 40, 42, 44 have respective apertures on the cover fitting side, so that such apertures are fully exposed and visible when the cover is removed from the casing 10. Furthermore, the pocket-like recesses 38, 40, 42, 44 are provided with respective splits 46, 48, 50, 52 that look out upon the interior of the second section 26 and are continuous to the respective ones of the above-mentioned apertures when the cover is raised.

The first side wall 30 and the second side wall 32 are joined to the demarcation surface 28 and to a thinner wall 36 extending thereacross in a position opposite to said demarcation surface 28. The transverse wall 36 sets a longitudinal limit to, i.e. marks the longitudinal boundary of the bistable Hall-effect magnetic proximity sensor.

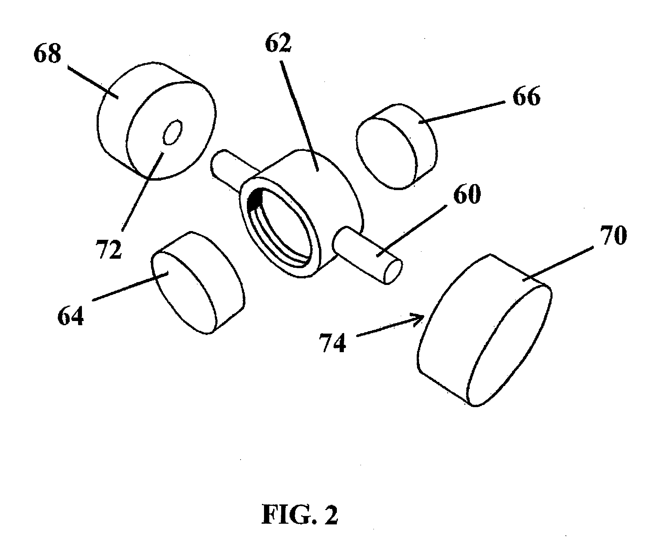

Referring now also to Figure 2, it can be noticed that each one of said first and second magnetic element 16, 18 may be made and provided to substantially include a pin 60, a bearing 62, a first magnetic piece 64, a second magnetic piece 66, a first bush 68 and a second bush 70.

In this embodiment of the present invention, for example, the bearing 62 is in a cylindrical shape and features two cavities separated by a partition, inside which the pin 60 is co-moulded, in such manner as to enable the same pin 60 to extend from the bearing 62 on both sides thereof. In another embodiment of the present invention, for example, the bearing 62 is in a hollow cylindrical shape and the pin 60 is able to be fitted into a pair of bores provided in a diametrically opposite arrangement in the bearing 62 so that the same pin 60 is able to extend from the bearing 62 on both sides thereof. The magnetic pieces 64, 66 are secured inside the respective ones of the two cavities lying diametrically opposite relative to the pin 62. Each end of the pin is coupled by fitting it into one of the bores 72, 74 provided in the bushes 68, 70, respectively.

The first magnetic element 16 may be housed in the second section 26 by for instance fitting the bush 68 into the pocket-like recess 38 and the bush 70 into the pocket-like recess 42, or vice-versa. Similarly, the second magnetic element 18 may be housed in the second section 26 by fitting the respective bushes thereof into the pocket-like recesses 40, 44. The bushes 68, 70 are fitted so as to become firmly joined with the respective walls 30, 32, and the pin 60 is journalled in a freely rotatable manner inside the bores 72 and 74.

This kind of coupling allows for free rotation of both the first magnetic element 16 and the second magnetic element 18 inside the second section 26.

Advantageously, the pin 60 is made of a metal material, such as for instance stainless steel, which is different from the one used to make the bushes 68, 70, such as for instance brass or bronze, so that each magnetic element 16, 18 turns out as being self-lubricating, and this obviously allows each such magnetic element 16, 18 to rotate very smoothly under reduced friction and noise.

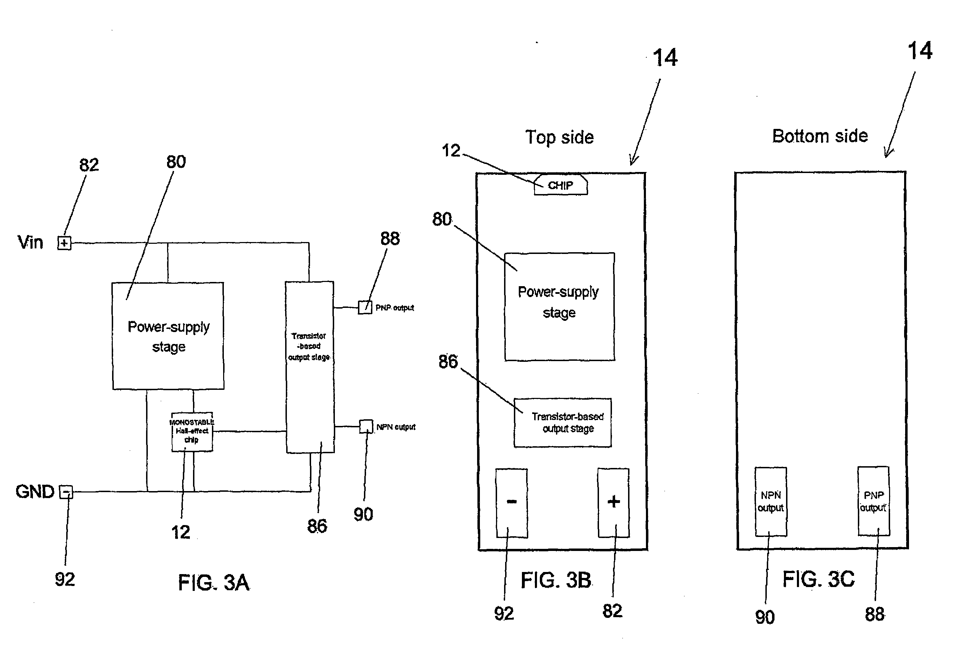

Figures 3A, 3B and 3C illustrate a first basic circuit diagram of the sensor shown in Figure 1 with a transistor-based output and the related printed-circuit board 14. The circuit substantially comprises a power-supply stage 80, the monostable Hall-effect chip 12, and a transistor-based output stage 86.

The power-supply stage 80 is used to energize the monostable Hall-effect chip 12 and a transistor-based output stage 86 with a current that is roughly constant and independent of the supply voltage delivered to the power-supply terminal 82. From the transistor-based output stage 86 there are taken out the terminals of a PNP output 88 and a NPN output 90. The sensor, with a single one of these outputs 88, 90 being made available, has three lead wires connected to the afore-cited lands of the printed-circuit board 14: specifically, a first lead wire connected to the power-supply terminal 82, a second lead wire connected to the grounding terminal 92, and a third lead wire connected to the desired one of the two transistor-based output terminals that is due to be fed. In the case that both transistor-based outputs 80, 90 are made available, a further lead wire is added for connection to the other transistor-based output terminal.

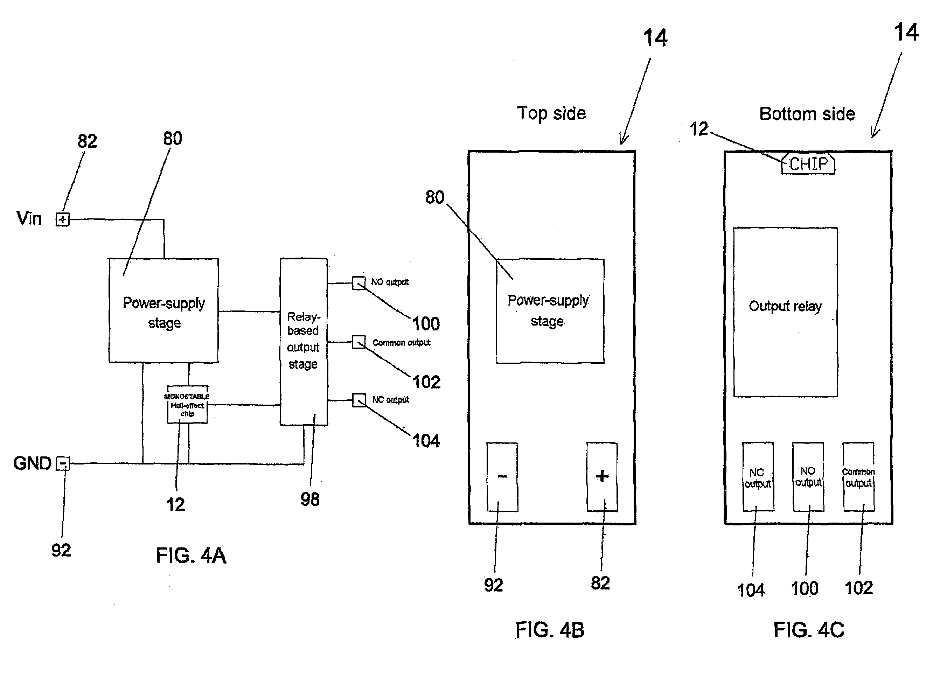

Figures 4A, 4B and 4C illustrate a second basic circuit diagram of the sensor shown in Figure 1 with a relay-based output and the related printed-circuit board 14, according to a modified embodiment of the present invention, wherein the same reference numerals are used to indicate all those parts and items that are similar and common to the ones used in the formerly described embodiment of the present invention.

A power-supply stage 80 is used again to energize the monostable Hall-effect chip 12 and a relay-based output stage 98 with a current that is roughly constant and independent of the supply voltage delivered to the power-supply terminal 82. The relay-based output stage comprises a relay whose trip coil is controlled by the monostable Hall-effect chip 12. From this relay-based output stage 98 there are taken out the terminals of a common-branch output, a NO (normally open contact) output 100 and a NC (normally closed contact) output 104. The sensor has five lead wires connected to the afore-cited lands of the printed-circuit board 14: specifically, a first lead wire connected to the power-supply terminal 82, a second lead wire connected to the grounding terminal 92, a third lead wire connected to the terminal of the NO output 100, a fourth lead wire connected to the terminal of the common-branch output 102, and a fifth lead wire connected to the terminal of the NC output 104.

When using, i.e. supplying all above-mentioned outputs 100, 102, 104, the operation of the sensor can be the typical one of an exchange-mode bistable, whereas, if either one of the NO output 100 and NC output 104 is excluded, the operation of the sensor can be the typical one of a simple bistable.

The cable being used may be either a single multipolar, i.e. composite cable including both power-supply conductors and signal-carrying wires, or it may comprise two separate cables, one of which is a bipolar one for power-supply wires only, whereas the other one is a multipolar one that includes signal-carrying wires. In both cases, the cables come out from the rear threaded cylindrical part 22.

The bistable Hall-effect magnetic proximity sensor may further be provided with a LED-indicator light (not shown) to deliver a visual indication of the state of the output.

From an operation point of view, the magnetic element 18 may be driven, i.e. actuated by a magnetic flux generated by a first external magnetic body (not shown). The magnetic element 18 is therefore able to rotate to thereby position itself so as to be facing said first external magnetic body with a polarity of an opposite sign.

The magnetic element 16 may in turn be driven, i.e. actuated by a magnetic flux generated by the magnetic element 18, or even by the magnetic flux generated by the first external magnetic body. The magnetic element 16 is therefore able to rotate to thereby position itself so as to be facing the magnetic element 18 with a polarity of an opposite sign.

The two rotating magnetic elements 16, 18 remain in a first configuration relating to one of the two stable state until they come at and pass by a second external magnetic body that offers an opposite polarity as compared with the one of the first external magnetic element. In this case, the magnetic elements 16, 18 will therefore be caused to rotate in a similar manner as described afore, until they reach a second configuration relating to the other stable state.

The bistable Hall-effect magnetic proximity sensor is kept in either one of the two stable states thereof by virtue of the magnetic attraction that is established between the two rotating magnetic elements 16, 18, regardless of the power supply to the sensor.

In the first configuration thereof, the rotating magnetic elements 16, 18 are oriented with a respective NORTH polarity thereof towards the monostable Hall-effect chip 12, which does therefore not deliver any signal, since it is not activated.

In the second configuration thereof, the rotating magnetic elements 16, 18 are oriented with a respective SOUTH polarity thereof towards the monostable Hall-effect chip 12, which therefore delivers a signal, since it is activated.

When used in conjunction with a control system for controlling the movement of a moving platform, such as a lift or elevator installation, to indicate an end-of-travel condition of the elevator cage, the bistable Hall-effect magnetic proximity sensor according to the present invention is capable of correctly issuing a signal indicating an activation or de-activation state thereof under any operating circumstance and condition. In fact, correct operation in the case of a temporary power-supply failure is anyway ensured by the position of the rotating magnetic elements, which, as this has been described afore, rotate depending on or according to the polarity of an external magnetic body in a manner that is fully independent of a power supply being or not being delivered to the sensor, actually.

In particular, when the above-cited sensor installed in the elevator cage passes by or close to one of the external magnetic bodies, which are provided in the elevator shaft in a position located in advance of a topmost floor and/or a bottommost floor, under a power-supply failure condition of the same sensor, the state of activation can be switched over, i.e. change into the de-activation state owing to the magnetic interaction of the magnetic elements 16, 18 with said external magnetic body, and this configuration of the magnetic elements 16, 18 shall then be kept as such in the same manner as described afore. When the power supply is eventually restored, the above-mentioned sensor shows correctly up in the de-activation state thereof, thereby delivering the correct signal to a control unit of the above-noted control system.

Fully apparent from the above description is therefore the ability of the bistable Hall-effect magnetic proximity sensor according to the present invention to effectively reach the aims and advantages cited afore, by in fact providing a bistable Hall-effect magnetic proximity sensor that is able to maintain its state under any operating circumstance and condition whatsoever, wherein the state of the bistable Hall-effect magnetic proximity sensor is maintained owing to the magnetic attraction that is established by the pair formed of the first magnetic element 16 and the second magnetic element 18, regardless of a power supply being or not being delivered to the sensor.

It shall be appreciated that the materials used, as well as the shape and the sizing of the various parts of the inventive tub assembly may each time be selected so as to more appropriately meet the particular requirements or suit the particular application. It shall further be appreciated that the various elements forming the object of and being part of the present invention shall certainly not be solely embodied in the manners that has been described and illustrated hereinbefore, but can rather be implemented in many other embodiments - although not specifically illustrated here - without departing from the scope of the present invention.

## Claims

1. Bistable magnetic proximity sensor comprising a case (10) and a Hall-effect chip (12), said Hall-effect chip (12) of the monostable kind, said Hall-effect chip being housed in said case at least a first magnetic element (16), and a second magnetic element (18), **characterized by** said first magnetic element (16) and said second magnetic element (18) being respectively housed in said case (10) so as to both be able to rotate in view of maintaining a condition of mutual magnetic attraction thereby orienting a respective polarity of the same sign of the magnetic elements thereof towards said Hall-effect chip (12).

2. Bistable magnetic proximity sensor according to claim 1, wherein each bipolar magnetic element (16, 18) comprises a pin (60) whose end portions are coupled with respective bushes (68, 70) so as to be able to rotate, said bushes being housed in a firmly joined manner in respective accommodations provided in the case (10).

3. Bistable magnetic proximity sensor according to claim 2, wherein said pin (60) and said bushes (68, 70) are made of different metal materials.

4. Bistable magnetic proximity sensor according to any of the preceding claims, wherein at least one out of said first and said second rotating magnetic elements (16, 18) is adapted to be driven, i.e. actuated by a magnetic flux of an external magnetic body so as to maintain the sensor in a condition of stability.

5. Bistable magnetic proximity sensor according to any of the preceding claims, wherein said sensor further comprises a relay, a coil of said relay being controlled by said Hall-effect chip (12).

6. Bistable magnetic proximity sensor according to any of the preceding claims, wherein said sensor comprises an output with at least one of the configurations out of a NPN transistor-based output, a PNP transistor-based output, and an output supplied by the contacts of the relay.

7. Bistable magnetic proximity sensor according to claim 5 or 6, wherein said sensor is an exchange-mode bistable one.

8. Control system comprising sensor means for controlling the movement of a moving platform, **characterized in that** said sensor means comprise at least a bistable magnetic proximity sensor according to any of the claims 1 to 7.

## Patentansprüche

1. Bistabiler magnetischer Annäherungssensor, der ein Gehäuse (10) und einen Hall-Effekt-Chip (12) aufweist, wobei der Hall-Effekt-Chip (12) vom monostabilen Typ ist, und der Hall-Effekt-Chip in dem Gehäuse untergebracht ist, und er zumindest ein erstes Magnetelement (16) und ein zweites Magnetelement (18) aufweist, **dadurch gekennzeichnet, dass** das erste Magnetelement (16) und das zweite Magnetelement (18) jeweils in dem Gehäuse (10) so untergebracht sind, dass sie beide fähig sind, zu rotieren, im Hinblick auf ein Beibehalten eines Zustandes einer gegenseitigen magnetischen Anziehung, wodurch eine jeweilige Polarität gleichen Vorzeichens der magnetischen Elemente in Richtung zu dem Hall-Effekt-Chip (12) ausgerichtet wird.

2. Bistabiler magnetischer Annäherungssensor nach Anspruch 1, wobei jedes bipolare Magnetelement (16, 18) einen Stift (60) aufweist, dessen Endabschnitte mit jeweiligen Buchsen (68, 70) verbunden sind, so dass er fähig ist, zu rotieren, wobei die Buchsen in fest verbundener Weise in jeweiligen im Gehäuse (10) vorgesehenen Aufnahmen untergebracht sind.

3. Bistabiler magnetischer Annäherungssensor nach Anspruch 2, wobei der Stift (60) und die Buchsen (68, 70) aus unterschiedlichen Metallmaterialien bestehen.

4. Bistabiler magnetischer Annäherungssensor nach einem der vorhergehenden Ansprüche, wobei mindestens eines von dem ersten und zweiten rotierenden Magnetelement (16, 18) ausgebildet ist, um angetrieben zu werden, d. h. durch einen magnetischen Fluss eines externen magnetischen Körpers betätigt zu werden, so dass der Sensor in stabilem Zustand gehalten wird.

5. Bistabiler magnetischer Annäherungssensor nach einem der vorhergehenden Ansprüche, wobei der Sensor weiter ein Relais aufweist, wobei eine Spule des Relais durch den Hall-Effekt-Chip (12) gesteuert wird.

6. Bistabiler magnetischer Annäherungssensor nach einem der vorhergehenden Ansprüche, wobei der Sensor einen Ausgang mit mindestens einem der folgenden Konfigurationen aufweist, und zwar einen Ausgang auf Basis eines NPN-Transistors, einen Ausgang auf Basis eines PNP-Transistors, und einen Ausgang, der durch die Kontakte des Relais versorgt wird.

7. Bistabiler magnetischer Annäherungssensor nach Anspruch 5 oder 6, wobei der Sensor einer vom bistabilen Wechselmodus-Typ ist.

8. Steuersystem, das eine Sensoreinrichtung zum Steuern der Bewegung einer beweglichen Plattform aufweist, **dadurch gekennzeichnet, dass** die Sensoreinrichtung zumindest einen bistabilen magnetischen Annäherungssensor nach einem der Ansprüche 1 bis 7 aufweist.

## Revendications

1. Capteur de proximité magnétique bistable comprenant un boîtier (10) et une puce à effet Hall (12) de type monostable, ladite puce à effet Hall étant logée dans ledit boîtier (10), et au moins un premier élément magnétique (16) et un second élément magnétique (18), **caractérisé en ce que** ledit premier élément magnétique (16) et ledit second élément magnétique (18) sont logés respectivement dans ledit boîtier (10) de façon à être tous les deux capables de tourner en vue du maintien d'un état d'attraction magnétique mutuelle orientant ainsi une polarité respectivement de même signe que les éléments magnétiques en direction de ladite puce à effet Hall (12).

2. Capteur de proximité magnétique bistable selon la revendication 1, dans lequel chaque élément magnétique bipolaire (16, 18) comprend une tige (60) dont les extrémités sont couplées respectivement avec des bagues (68, 70) de manière à pouvoir tourner, lesdites bagues étant logées fermement dans les logements respectifs prévus dans le boitier (10).

3. Capteur de proximité magnétique bistable selon la revendication 2, dans lequel ladite tige (60) et lesdites bagues (68, 70) sont en matériaux métalliques différents.

4. Capteur de proximité magnétique bistable selon l'une des revendications précédentes, dans lequel au moins un dudit premier et dudit second des éléments magnétiques (16, 18) en rotation est adapté pour être entraîné, c'est à dire actionné par un flux magnétique d'un corps magnétique externe de manière à maintenir le capteur dans un état de stabilité.

5. Capteur de proximité magnétique bistable selon l'une des revendications précédentes, dans lequel ledit capteur comprend en outre un relais, une bobine dudit relais étant commandée par ladite puce à effet Hall (12).

6. Capteur de proximité magnétique bistable selon l'une des revendications précédentes, dans lequel ledit capteur comprend une sortie ayant au moins une des configurations suivantes : sortie d'un transistor NPN, sortie d'un transistor PNP, et sortie fournie par les contacts d'un relais.

7. Capteur de proximité magnétique bistable selon la revendication 5 ou 6, dans lequel ledit capteur est un capteur bistable en mode échange.

8. Système de commande comprenant des moyens de détection pour commander le mouvement d'une plate-forme mobile, **caractérisé en ce que** lesdits moyens de détection comprennent au moins un capteur de proximité magnétique bistable selon l'une quelconque des revendications 1 à 7.
